(19) Europäisches Patentamt
European Patent Office
Office européen des brevets

(11) **EP 2 507 417 B1**

(12) **FASCICULE DE BREVET EUROPEEN**

(45) Date de publication et mention de la délivrance du brevet:
**06.11.2013 Bulletin 2013/45**

(21) Numéro de dépôt: **10785415.0**

(22) Date de dépôt: **30.11.2010**

(51) Int Cl.:
*C30B 11/00* (2006.01)    *C30B 35/00* (2006.01)
*C30B 28/06* (2006.01)    *C30B 29/06* (2006.01)

(86) Numéro de dépôt international:
**PCT/EP2010/068537**

(87) Numéro de publication internationale:
**WO 2011/064391 (03.06.2011 Gazette 2011/22)**

(54) **DISPOSITIF DE CONTRÔLE DE L'ÉTAT D'AVANCEMENT DE LA CRISTALLISATION D'UN BAIN DE MATÉRIAU FONDU DANS UN PROCÉDÉ DE SOLIDIFICATION DIRIGÉE UTILISANT LES ULTRASONS**

VORRICHTUNG ZUR ÜBERWACHUNG DES KRISTALLISIERUNGSFORTSCHRITTS EINES SCHMELZEBADES IN EINEM DIREKTIONALEN ERSTARRUNGSVERFAHREN MIT ULTRASCHALL

DEVICE FOR MONITORING THE PROGRESS OF CRYSTALLIZATION OF A BATH OF MOLTEN MATERIAL IN A DIRECTIONAL SOLIDIFICATION PROCESS EMPLOYING ULTRASOUND

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **30.11.2009 FR 0958523**

(43) Date de publication de la demande:
**10.10.2012 Bulletin 2012/41**

(73) Titulaires:
• **Commissariat à l'Énergie Atomique et aux Énergies Alternatives**
  **75015 Paris (FR)**
• **Centre National de la Recherche Scientifique**
  **75016 Paris (FR)**

(72) Inventeurs:
• **GARANDET, Jean-Paul**
  **F-73370 Le Bourget du Lac (FR)**
• **BOTTON, Valery**
  **F-38510 Saint-Sorlin de Morestel (FR)**
• **SALVI, Charles**
  **F-38000 Grenoble (FR)**

(74) Mandataire: **Ilgart, Jean-Christophe et al**
**BREVALEX**
**95 rue d'Amsterdam**
**75378 Paris Cedex 8 (FR)**

(56) Documents cités:
**EP-A2- 1 754 809**

• **DOLD P ET AL: "In situ observation of growth interfaces by ultrasound", JOURNAL OF CRYSTAL GROWTH, ELSEVIER, AMSTERDAM, NL LNKD- DOI:10.1016/S0022-0248(03)01405-2, vol. 256, no. 3-4, 1 septembre 2003 (2003-09-01), pages 352-360, XP004440645, ISSN: 0022-0248 cité dans la demande**
• **GUDRA T ET AL: "SCANNING ACOUSTIC AIR MICROSCOPE", ULTRASONICS, IPC SCIENCE AND TECHNOLOGY PRESS LTD. GUILDFORD, GB LNKD- DOI:10.1016/0041-624X(96)80003-C, vol. 34, no. 7, 1 octobre 1996 (1996-10-01), pages 711-719, XP000633768, ISSN: 0041-624X cité dans la demande**
• **S. ECKERT, G. GERBETH, V.I. MELNIKOV: "velocity measurements at high temperatures by ultrasound doppler velocimetry using an acoustic wave guide", EXPERIMENTS IN FLUIDS, vol. 35, 1 novembre 2003 (2003-11-01), pages 381-388, XP002584836,**

**Description**

**DOMAINE TECHNIQUE**

L'invention concerne un dispositif et un procédé permettant de contrôler l'état d'avancement de la cristallisation d'un bain de matériau fondu, en particulier un bain de silicium, la cristallisation étant réalisée dans une enceinte thermiquement isolante d'un four de cristallisation selon un procédé de solidification dirigée.

Le dispositif et le procédé selon l'invention permettent en fait de détecter la position et la vitesse de l'interface liquide-vapeur du bain de matériau fondu. A partir de la mesure de la position (de la vitesse) de l'interface liquide-vapeur, on peut également connaitre la position (la vitesse) de l'interface solide-liquide.

**ÉTAT DE LA TECHNIQUE ANTÉRIEURE**

Les techniques de solidification dirigée sont actuellement les techniques standards utilisées pour l'élaboration de lingots de matériaux semiconducteurs cristallins pour des applications en microélectronique et en optoélectronique. Ces techniques sont en particulier utilisées pour la réalisation de silicium photovoltaïque.

Les techniques de solidification dirigée sont des procédés de solidification mettant en oeuvre un gradient thermique uniaxial permettant de favoriser la croissance privilégiée des grains des cristaux dans le sens du gradient imposé.

Dans ces procédés d'élaboration par solidification dirigée, la position et la vitesse de l'interface solide-liquide sont des paramètres fondamentaux. En effet, une mesure précise de la position de l'interface solide-liquide est nécessaire pour initier la cristallisation de façon reproductible, tandis que la vitesse de solidification est une variable clé pour le contrôle de la ségrégation des impuretés et la déstabilisation morphologique du front de croissance. De plus, la vitesse de solidification gouverne directement la productivité du procédé d'élaboration par solidification dirigée et doit être optimisée en fonction des spécificités du matériau et du dispositif de solidification utilisés.

Il existe différentes techniques permettant de localiser l'interface solide-liquide dans les procédés de solidification dirigée.

La position de l'interface solide-liquide peut être déterminée par palpage mécanique de la phase solide au travers de la phase liquide au moyen d'une canne en céramique réfractaire. Ce procédé est actuellement utilisé dans des conditions de croissance industrielles. Ce procédé est robuste, mais il est peu précis et mal adapté à la phase de solidification, où on observe une cristallisation et un collage du matériau en cours de solidification autour de la canne réfractaire. De plus, certains matériaux, et en particulier le silicium liquide, ont une forte réactivité et la canne en céramique réfractaire devient alors une source de pollution.

Il est également possible de mesurer la résistance électrique de l'échantillon au cours de sa solidification. Cette technique est basée sur le fait que les résistivités des phases solide et liquide sont généralement différentes, ce qui permet de localiser l'interface solide-liquide. Cette technique est extrêmement précise, l'incertitude sur la position de l'interface étant de quelques micromètres (voir le document **[1]** référencé à la fin de la description).

Cette technique est cependant très sensible aux perturbations électromagnétiques de l'environnement et est donc mal adaptée à un environnement industriel. Elle suppose par ailleurs de prendre un contact électrique sur le matériau liquide, ce qui, dans le cas de certains matériaux comme par exemple le silicium liquide, est source de difficultés.

Il est également possible de mesurer le temps de vol d'un écho ultrasonore, émis par un transducteur collé sur la phase solide du matériau, qui se réfléchit partiellement sur l'interface solide-liquide du fait d'une différence d'impédance mécanique entre la phase liquide et la phase solide. La précision de cette technique est satisfaisante : elle est de l'ordre de la dizaine de micromètres (voir le document **[2]**).

Cette technique suppose cependant de pouvoir accéder à la phase solide en partie froide (c'est-à-dire à l'opposé de l'interface liquide-solide), ce qui complique la conception du dispositif de mesure et qui exclut les procédés utilisant une fusion complète du matériau. Il est en outre nécessaire de disposer d'une colle permettant le couplage entre le transducteur et la phase solide, ce qui limite cette technique à des matériaux ayant une température de fusion inférieure à 1000°C.

Aucune des techniques détaillées ci-dessus ne permet d'obtenir la mesure de la position, et éventuellement de la vitesse, d'une interface solide-liquide dans des dispositifs de solidification dirigée verticaux au moyen d'une technique robuste, utilisable en configuration industrielle et adaptable à plusieurs environnements gazeux. Les inventeurs se sont donc fixé comme but de combler cette lacune.

**EXPOSÉ DE L'INVENTION**

Ce but est atteint grâce à un dispositif de contrôle de l'état d'avancement de la cristallisation d'un bain de matériau fondu réalisée dans une enceinte thermiquement isolante d'un four de cristallisation selon un procédé de solidification dirigée, comprenant une source d'ultrasons et un détecteur d'ultrasons, caractérisé en ce que :

- la source d'ultrasons comprend n ensemble(s), n étant un nombre entier supérieur ou égal à 1, chaque ensemble de la source comprenant un transducteur, apte à émettre une onde ultrasonore, relié à un guide d'onde, apte à guider l'onde ultrasonore, produite par ledit transducteur, vers l'interface vapeur-liquide du bain liquide ;
- le détecteur d'ultrasons comprend au moins 2n ensembles, chaque ensemble du détecteur comprenant un guide d'onde relié à un transducteur apte à détecter une onde ultrasonore, ledit guide d'onde étant apte à guider une onde ultrasonore vers ledit transducteur ;

et caractérisé en ce que les n ensembles de la source et les au moins 2n ensembles du détecteur sont placés au dessus de l'interface vapeur-liquide du bain liquide en des positions distinctes telles que l'onde ultrasonore produite par un transducteur de la source soit incidente sur l'interface vapeur-liquide selon un angle aigu par rapport à la normale à ladite interface et que cette onde ultrasonore, réfléchie par l'interface vapeur-liquide selon ce même angle aigu, soit détectée par un transducteur du détecteur,

les transducteurs de la source et du détecteur sont situés à l'extérieur de l'enceinte et les guides d'onde de la source et du détecteur traversent la paroi de ladite enceinte,

et les guides d'onde comprennent une face d'entrée d'une onde ultrasonore, une face de sortie d'une onde ultrasonore et une surface latérale reliant ces deux faces, les faces parmi les faces d'entrée et les faces de sortie des guides d'onde qui pointent vers l'intérieur de l'enceinte étant recouvertes d'une couche poreuse permettant d'assurer une adaptation d'impédance entre les guides d'onde et l'atmosphère de l'enceinte, ladite couche poreuse ayant une densité inférieure à $1000 \text{ kg/m}^3$.

Les faces qui pointent vers l'intérieur de l'enceinte sont en fait les faces des guides d'onde qui vont être en contact avec la vapeur présente dans l'enceinte au cours de la fonte du matériau du bain. Selon l'invention, la surface de ces faces est recouverte d'une couche poreuse, qui permet d'assurer une adaptation d'impédance entre le guide d'onde et l'atmosphère de l'enceinte.

Une couche poreuse se caractérise par une densité inférieure à $1000 \text{ kg/m}^3$, avantageusement inférieure à $500 \text{ kg/m}^3$.

La couche poreuse a une épaisseur comprise de préférence entre 20 et 1000 micromètres, avantageusement entre 50 et 200 micromètres.

Les guides d'onde sont des corps pleins comprenant une face d'entrée d'une onde ultrasonore (une première extrémité), une face de sortie d'une onde ultrasonore (une seconde extrémité) et une surface latérale reliant la face d'entrée et la face de sortie. La section droite des guides d'onde peut être indifféremment circulaire, oblongue ou polygonale (par exemple triangulaire, rectangulaire, carrée, hexagonale...). De préférence, les guides d'onde ont une section circulaire et sont rectilignes ; ce sont par exemple des barreaux.

De préférence, les guides d'onde sont positionnés de sorte qu'une de leurs faces (face d'entrée pour la source et face de sortie pour le détecteur) soit fixée directement à un transducteur et que l'autre face (face de sortie pour la source et face d'entrée pour le détecteur) pointe vers l'interface vapeur-liquide.

On rappelle qu'une onde ultrasonore (ou ultrason) est une onde vibratoire mécanique d'une fréquence supérieure à la fréquence limite perceptible par l'oreille humaine. Il englobe généralement toutes les fréquences au delà de 16 kHz. La limite supérieure de fréquence des ondes ultrasonores dépend largement du générateur ; elle peut aller jusqu'à quelques centaines de Mégahertz.

Le matériau fondu présente une variation de volume à la solidification supérieure à 5% (avantageusement supérieure à 10%) ; il peut être par exemple un semi-conducteur comme le silicium ou le germanium ou un oxyde comme le niobate de lithium ($LiNbO_3$) ou le YAG (« Yttrium Aluminium Garnet » en anglais ou grenat d'yttrium et d'aluminium en français ($Y_3Al_5O_{12}$)).

Avantageusement, la couche poreuse est un aérogel de silice cristalline ou une mousse de graphite expansé, c'est-à-dire un graphite expansé réalisé par décomposition thermique d'un précurseur issu de la réaction d'un graphite naturel avec de l'acide sulfurique.

Avantageusement, la couche poreuse a une densité inférieure à $1000 \text{ kg/m}^3$, de préférence inférieure à $500 \text{ kg/m}^3$

Avantageusement, les guides d'onde de la source et du détecteur sont en silice cristalline ou en alumine cristalline.

De préférence, la ou les n guides d'onde de la source sont disposées selon une ligne essentiellement parallèle à l'interface vapeur-liquide du bain liquide ou bien selon une matrice dont la ou les lignes sont essentiellement parallèles à l'interface vapeur-liquide.

De même, les au moins 2n guides d'onde du détecteur sont de préférence disposés selon une ligne ou selon une matrice dont la ou les lignes sont essentiellement parallèles à l'interface vapeur-liquide.

Avantageusement, les guides d'onde du détecteur sont disposés selon une matrice (ixj), avec i lignes et j colonnes, i et j étant des nombres entiers supérieurs ou égaux à 1 et i×j ≥ 2.

Avantageusement, l'angle aigu est compris entre 40° et 70°. De préférence, l'angle aigu est compris entre 50° et 60°.

Avantageusement, les transducteurs de la source et du détecteur sont des transducteurs du type piézoélectrique ou magnétostrictif.

L'invention concerne également un procédé de contrôle de l'état d'avancement de la cristallisation d'un bain de matériau fondu réalisée dans une enceinte thermiquement isolante d'un four de cristallisation selon un procédé de solidification dirigée, ledit matériau ayant un coefficient de variation de volume à la solidification connu et différent de 0, ledit procédé comprenant les étapes suivantes :

- détection de la position de l'interface vapeur-liquide du bain de matériau fondu au temps (t) ;
- déduction de la position de l'interface liquide-solide au temps (t) par l'intermédiaire du calcul de la variation de la position de l'interface liquide-solide entre l'instant (t) et un instant initial, en multipliant la variation de la position de l'interface vapeur-liquide entre l'instant (t) et l'instant initial par le coefficient $\rho_{liq} / (\rho_{liq} + \rho_{sol})$, où $\rho_{liq}$ et $\rho_{sol}$ représentent respectivement la masse volumique du matériau liquide et la masse volumique du matériau solide ; le procédé étant caractérisé en ce que l'étape de détection de la position de l'interface vapeur-liquide comprend les étapes suivantes :
- envoi d'une onde ultrasonore sur l'interface vapeur-liquide selon un angle aigu par rapport à la normale à l'interface vapeur-liquide ;
- détection de l'onde ultrasonore réfléchie par l'interface vapeur-liquide ;

l'envoi et la détection de l'onde ultrasonore se faisant à l'aide du dispositif de contrôle selon l'invention.

Selon une première variante, le procédé comprend en outre, après l'étape de détection de la position de l'interface vapeur-liquide, les étapes suivantes :

- détection de la position z de l'interface vapeur-liquide du bain de matériau fondu au temps (t+a), a étant le laps de temps séparant la détection au temps (t) et la détection au temps (t+a) ;
- détermination de la vitesse de l'interface vapeur-liquide selon la formule suivante :

$$V_{vapeur\text{-}liquide} = \frac{z(t + a) - z(t)}{a}$$

D'autres formules peuvent être utilisées, en particulier une formule faisant intervenir des moyennes sur plusieurs mesures temporelles.

Selon une seconde variante, le procédé comprend en outre, après l'étape de détection de la position de l'interface vapeur-liquide, les étapes suivantes :

- détection de la position z de l'interface vapeur-liquide du bain de matériau fondu au temps (t+a), a étant le laps de temps séparant la détection au temps (t) et la détection au temps (t+a) ;
- déduction de la position z' de l'interface liquide-solide au temps (t+a) par l'intermédiaire du calcul de la variation de la position de l'interface liquide-solide entre l'instant (t+a) et l'instant (t), en multipliant la variation de la position de l'interface vapeur-liquide entre l'instant (t+a) et l'instant (t) par le coefficient $\rho_{liq} / (\rho_{liq} + \rho_{sol})$, où $\rho_{liq}$ et $\rho_{sol}$ représentent respectivement la masse volumique du matériau liquide et la masse volumique du matériau solide ;
- détermination de la vitesse de l'interface liquide-solide selon la formule suivante :

$$V_{liquide\text{-}solide} = \frac{z'(t + a) - z'(t)}{a}$$

D'autres formules peuvent être utilisées, en particulier une formule faisant intervenir des moyennes sur plusieurs mesures temporelles.

Le détecteur selon l'invention permet de détecter la position de l'interface liquide-vapeur d'un matériau fondu. Le détecteur selon l'invention permet par exemple de suivre la croissance d'un lingot dans un four de cristallisation vertical, à partir d'un bain de matériau fondu, par exemple un bain de silicium.

A partir de là position de l'interface liquide-vapeur, on peut remonter, par des calculs, à la position de l'interface solide-liquide. Cette manière de procéder est plus pratique que les techniques connues de l'art antérieur qui consistent à détecter directement la position de l'interface solide-liquide. Les vitesses des interfaces liquide-solide et vapeur-liquide sont corrélées via la variation de masse volumique du matériau à la cristallisation. Par exemple, pour le silicium, la variation de masse volumique à la cristallisation est typiquement de l'ordre de 10%.

Contrairement aux dispositifs de l'art antérieur, la source d'ultrasons et le détecteur d'ultrasons sont placés au dessus du bain de matériau fondu, à savoir au dessus de l'interface vapeur-liquide. Cette solution est particulièrement ingénieuse et va à l'encontre des a *priori* de l'homme du métier. En effet, l'utilisation d'ondes ultrasonores en incidence oblique sur l'interface liquide-vapeur d'un bain liquide oblige à placer la source et le détecteur d'ultrasons dans une zone chaude de l'enceinte de cristallisation, la chaleur dégagée lors de la fusion du matériau endommageant alors la source et le détecteur d'ultrasons, ou à créer des ouvertures dans l'enceinte de cristallisation afin de placer la source et le récepteur d'ultrasons à l'extérieur de l'enceinte et laisser passer les ondes ultrasonores. Or l'homme du métier répugne à créer des ouvertures dans une enceinte de cristallisation dans les environnements haute température, car ces ouvertures sont des zones de fuite thermique qui détériorent les performances de cristallisation de l'enceinte. Dans l'invention, les fuites thermiques sont limitées grâce à l'utilisation de guide d'ondes, dont la fonction principale est bien sûr de guider l'onde émise ou l'onde réfléchie et de la transférer vers un transducteur qui peut être déporté dans une zone refroidie de l'enceinte, mais qui présente également l'avantage de jouer le rôle de masse thermique et de limiter les fuites de chaleur par convection.

## BRÈVE DESCRIPTION DES DESSINS

L'invention sera mieux comprise et d'autres avantages et particularités apparaîtront à la lecture de la description qui va suivre, donnée à titre d'exemple non limitatif, accompagnée d'une figure qui représente, selon une coupe verticale, une enceinte isolante d'un four de cristallisation comprenant un dispositif de contrôle selon l'invention.

## EXPOSÉ DÉTAILLÉ DE MODES DE RÉALISATION PARTICULIERS

Nous allons à présent décrire le dispositif de contrôle selon l'invention.

On considère une enceinte thermiquement isolante (1) d'un four de cristallisation vertical (non représenté), par exemple un four de croissance de type HEM (pour Heat Exchanger Method en anglais) à chauffage résistif adapté à la croissance de silicium pour applications photovoltaïques et fonctionnant sous balayage d'argon. On précise que le four contient l'enceinte, qui elle-même contient le creuset dans lequel se situe le bain de matériau fondu.

Les dimensions du creuset 2 sont ici de $20 \times 20$ cm$^2$ pour la base et de 20 cm pour la hauteur.

Le creuset 2 est rempli avec des blocs de silicium de manière à obtenir un taux de compacité de l'ordre de 50% : la hauteur du bain fondu avant la solidification est donc d'environ 10 cm. Ainsi, en tenant compte de la variation de volume de 10% du silicium à la solidification, l'amplitude du mouvement de l'interface liquide-vapeur 3 est donc d'environ 1 cm.

La source d'ultrasons 5 et le détecteur d'ultrasons 6 sont placés l'un en face de l'autre sur des parois 100 latérales opposées de l'enceinte du four.

La source d'ultrasons 5 comporte en général un seul transducteur accompagné de son guide d'ondes. Le détecteur d'ultrasons 6 doit quant à lui comprendre au moins deux transducteurs accompagnés de leur guide d'onde respectif pour chaque ensemble transducteur et guide d'onde de la source. Ainsi, lorsque la source d'ultrasons comporte n ensembles transducteur et guide d'onde, le détecteur comprendra au moins 2n ensembles transducteur et guide d'onde, chaque ensemble transducteur et guide d'onde de la source étant associé au moins deux ensembles transducteur et guide d'onde de détecteur.

Le ou les transducteurs de l'émetteur d'ultrasons (source) et le ou les transducteurs du récepteur d'ultrasons (détecteur) peuvent être identiques ou différents. Les transducteurs choisis doivent bien entendu résister à la température et à la pression de fonctionnement du four. Les transducteurs peuvent être des transducteurs piézoélectriques ou des transducteurs magnétostrictifs.

Dans cet exemple de réalisation, l'émetteur d'ultrasons 5 (source) comporte un seul transducteur 7, tandis que le récepteur d'ultrasons 6 (détecteur) comporte plusieurs transducteurs 9 disposés en matrice. Ici, les transducteurs 7 et 9 sont des transducteurs piézoélectriques LiNbO$_3$, ayant une température de Curie de 1150°C et fonctionnant à 1 MHz.

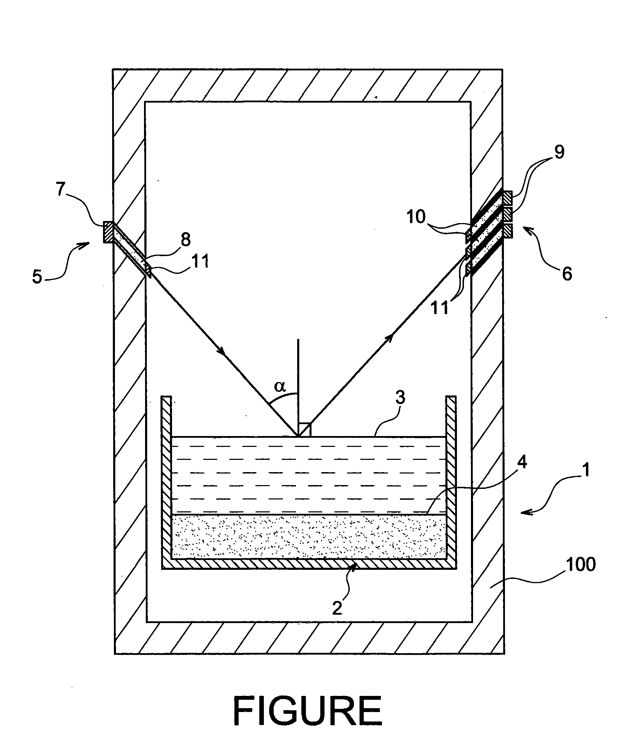

Comme illustré dans la figure, le transducteur 7 de l'émetteur et les transducteurs 9 du récepteur sont positionnés en dehors de l'enceinte de cristallisation, au dessus de l'interface liquide-vapeur et en vis-à-vis l'un de l'autre. De préférence, le transducteur de l'émetteur et les transducteurs du récepteur sont positionnés de manière symétrique par rapport au plan central du creuset.

Le transducteur de la source et les transducteurs du détecteur sont chacun respectivement connectés à un barreau de silice cristalline 8, 10. D'autres matériaux, comme l'alumine par exemple, peuvent être utilisés. Préférentiellement, ces matériaux seront sous forme cristalline et même sous forme monocristalline.

EP 2 507 417 B1

Dans l'exemple de réalisation, le transducteur 7 de la source est connecté à une extrémité d'un barreau parallélépipédique de silice cristalline 8 de section $10 \times 10$ mm$^2$ et de longueur 50 mm par un adhésif haute température, par exemple le Ceramabond® de la marque Aremco, le barreau traversant la paroi de l'enceinte thermiquement isolante.

Le détecteur comporte quant à lui une matrice constituée de 10x10 barreaux parallélépipédiques de silice cristalline 10 de section 1x1 mm$^2$ et de longueur 50 mm, qui traverse la paroi de l'enceinte isolante. Ces barreaux sont parallèles les uns aux autres et sont distants les uns des autres de 1 millimètre. A l'extrémité extérieure (c'est-à-dire pointant hors de l'enceinte) de chacun des barreaux 10 est placé un transducteur piézoélectrique 9. On utilise là encore un adhésif haute température pour fixer les barreaux à leur transducteur respectif.

En émission comme en réception, la face de sortie de l'onde du guide d'onde de la source et les faces d'entrée de l'onde des guides d'onde du détecteur, c'est-à-dire les faces des guides d'onde pointant vers l'intérieur de l'enceinte, sont recouverts d'une couche poreuse 11 qui a pour fonction d'adapter l'impédance entre le matériau solide du guide d'onde et la vapeur présente dans l'enceinte isolante. La couche poreuse a par exemple une épaisseur de 50 micromètres et les pores de la couche ont un diamètre de 1 à 10 nanomètres. Cette couche poreuse est par exemple une couche d'aérogel de silice obtenue par la technologie sol-gel.

Dans notre exemple de réalisation, les transducteurs 7 et 9 sont disposés directement sur la paroi extérieure de l'enceinte isolante, les barreaux traversent la totalité de l'épaisseur de la paroi de l'enceinte, l'extrémité extérieure (c'est-à-dire l'extrémité pointant vers l'extérieur de l'enceinte) de chaque barreau étant fixée à un transducteur et la face de l'extrémité intérieure étant recouverte d'une couche poreuse 11.

Les barreaux de silice sont orientés en direction de l'interface liquide-vapeur selon un angle d'incidence $\alpha$. Le choix de cet angle d'incidence $\alpha$ selon lequel l'onde ultrasonore arrive sur l'interface liquide-vapeur et s'y réfléchit résulte d'un compromis entre la résolution de la mesure et le souhait de déporter les points froids associés aux transducteurs le plus loin possible de l'interface liquide-vapeur. En effet, une variation $\Delta$h sur la hauteur physique de l'interface liquide-vapeur se traduit par une variation spatiale $\Delta h \times 2 \times \cos(\alpha)$ sur la position du spot réfléchi sur l'interface, ce qui tendrait à privilégier les faibles angles d'incidence, alors que le critère d'éloignement entre les transducteurs et l'interface tendrait à privilégier les forts angles d'incidence. Dans l'invention, l'angle d'incidence est choisi entre 40° et 70°, avantageusement entre 50° et 60°.

Dans cet exemple, nous avons placés les transducteurs à l'extérieur de l'enceinte de cristallisation à une hauteur de 15 cm de la surface du bain fondu avant la solidification. Les barreaux traversent la paroi de l'enceinte de cristallisation et sont orientés de manière à ce que l'angle d'incidence des ondes ultrasonores produites par le transducteur de la source et reçues par l'un des transducteurs du détecteur soit de l'ordre de 50°, cette valeur évoluant au cours de la solidification d'un angle de l'ordre de plus ou moins 5°.

La puissance du signal ultrasonore émis par le transducteur émetteur doit tenir compte des pertes liées au saut d'impédance acoustique entre le transducteur émetteur (le transducteur de la source), le milieu gazeux et le transducteur récepteur (un des transducteurs du récepteur). Dans la pratique, une puissance d'émission de l'ordre de 500 W/cm$^2$ suffit pour assurer que le signal de réception soit traitable, sous réserve de recouvrir les barreaux de silice d'une couche en matériau poreux permettant d'adapter l'impédance entre le gaz et le matériau solide du guide d'onde. L'utilisation de matériaux poreux pour adapter l'impédance entre les matériaux solide et gazeux est connue de l'homme du métier (voir par exemple le document **[3]).**

Par contre, étant donné que les pertes associées à la propagation du signal ultrasonore dans un milieu gazeux sont négligeables, la fréquence ultrasonore du signal n'est pas un paramètre fondamental. L'invention peut être mise en oeuvre sur une large gamme de fréquences dans le domaine des longueurs d'ondes ultrasonores, c'est-à-dire allant de 0,016 MHz à quelques centaines de MHz, de préférence allant de 0,1 à 100 MHz, et préférentiellement allant de 1 à 10 MHz.

L'onde ultrasonore (de fréquence 1 MHz) est produite par le transducteur émetteur de la source lorsqu'il est excité par un signal électrique de même fréquence. Après propagation à travers le guide d'onde (barreau de silice) et la vapeur comprise dans le four de cristallisation, l'onde ultrasonore arrive sur l'interface liquide-vapeur selon un angle d'incidence oblique, est réfléchie par cette interface et est ensuite détectée par un des transducteurs récepteurs du détecteur. Dans la figure, l'onde est ainsi réfléchie par l'interface silicium vapeur-silicium liquide selon un angle oblique.

Dans cet exemple, le détecteur comporte plusieurs transducteurs récepteurs organisés en matrice. Cela permet de déterminer la position de l'interface liquide-vapeur en fonction de la puissance reçue par les différents transducteurs récepteurs de la matrice.

En mesurant deux valeurs de position de l'interface vapeur-liquide 3 à intervalle de temps connu, on peut également connaitre la vitesse de déplacement de l'interface vapeur-liquide ; on peut également connaitre la vitesse du front de solidification (interface liquide-solide 4).

La source d'ultrasons peut également comporter plusieurs transducteurs. En, émettant des ondes ultrasonores à partir de chacun des transducteurs émetteurs, on peut obtenir des informations plus complètes sur la courbure de l'interface liquide/vapeur.

Un autre avantage du dispositif selon l'invention est qu'il peut être mis en oeuvre quel que soit le mode de chauffage utilisé (résistif, inductif...) utilisé dans le four de cristallisation. Ce dispositif permet en particulier de s'affranchir des perturbations électromagnétiques.

Ce dispositif rend possible le contrôle des procédés de solidification dirigée des matériaux semiconducteurs, en particulier pour l'élaboration de silicium photovoltaïque, par une méthode robuste fonctionnant à haute température. Ce dispositif est donc bien adapté à un environnement industriel.

**BIBLIOGRAPHIE**

[1] C. Salvi, J.P. Garandet, "A novel resistance technique in the field of directional solidification", Review of Scientific Instruments, 72 (2001), 255-262.

[2] P. Dold, M. Heidler, A. Drevermann, G. Zinimermann, «In situ observation of growth interfaces by ultrasound », Journal of Crystal Growth 256 (2003) 352-360)

[3] T. Gudra, Z. Kojro, M . Schmachtl, C. Lier, M. Schubert and W. Grill, «Scanning acoustic air microscope » Ultrasonics 34(1996)711-719).

**Revendications**

1. Dispositif de contrôle de l'état d'avancement de la cristallisation d'un bain de matériau fondu réalisée dans une enceinte thermiquement isolante d'un four de cristallisation selon un procédé de solidification dirigée, comprenant une source d'ultrasons (5) et un détecteur d'ultrasons (6), **caractérisé en ce que** :

   - la source d'ultrasons (5) comprend n ensemble(s), n étant un nombre entier supérieur ou égal à 1, chaque ensemble de la source comprenant un transducteur (7), apte à émettre une onde ultrasonore, relié à un guide d'onde (8), apte à guider l'onde ultrasonore, produite par ledit transducteur, vers l'interface vapeur-liquide (3) du bain liquide ;
   - le détecteur d'ultrasons (6) comprend au moins 2n ensembles, chaque ensemble du détecteur comprenant un guide d'onde (10) relié à un transducteur (9) apte à détecter une onde ultrasonore, ledit guide d'onde (10) étant apte à guider une onde ultrasonore vers ledit transducteur ;

   et **caractérisé en ce que** les n ensembles de la source et les au moins 2n ensembles du détecteur sont placés au dessus de l'interface vapeur-liquide (3) du bain liquide en des positions distinctes telles que l'onde ultrasonore produite par un transducteur de la source soit incidente sur l'interface vapeur-liquide selon un angle aigu par rapport à la normale à ladite interface et que cette onde ultrasonore, réfléchie par l'interface vapeur-liquide selon ce même angle aigu, soit détectée par un transducteur du détecteur,
   les transducteurs de la source et du détecteur sont situés à l'extérieur de l'enceinte et les guides d'onde de la source et du détecteur traversent la paroi de ladite enceinte,
   et les guides d'onde comprennent une face d'entrée d'une onde ultrasonore, une face de sortie d'une onde ultrasonore et une surface latérale reliant ces deux faces, les faces parmi les faces d'entrée et les faces de sortie des guides d'onde qui pointent vers l'intérieur de l'enceinte étant recouvertes d'une couche poreuse (11) permettant d'assurer une adaptation d'impédance entre les guides d'onde et l'atmosphère de l'enceinte, ladite couche poreuse ayant une densité inférieure à 1000 kg/m$^3$.

2. Dispositif de contrôle selon la revendication 1, dans lequel la couche poreuse est un aérogel de silice cristalline ou une mousse de graphite expansé.

3. Dispositif de contrôle selon la revendication 1, dans lequel la couche poreuse a une densité inférieure à 500 kg/m$^3$.

4. Dispositif de contrôle selon la revendication 1, dans lequel les guides d'onde de la source et du détecteur sont en silice cristalline ou en alumine cristalline.

5. Dispositif de contrôle selon la revendication 1, dans lequel les guides d'onde du détecteur sont disposés selon une matrice (ixj), avec i lignes et j colonnes, i et j étant des nombres entiers supérieurs ou égaux à 1 et i$\times$j $\geq$ 2.

**6.** Dispositif de contrôle selon la revendication 1, dans lequel l'angle aigu est compris entre 40° et 70°, de préférence entre 50° et 60°.

**7.** Dispositif de contrôle selon la revendication 1, dans lequel les transducteurs de la source et du détecteur sont des transducteurs du type piézoélectrique ou magnétostrictif.

**8.** Procédé de contrôle de l'état d'avancement de la cristallisation d'un bain de matériau fondu réalisée dans une enceinte thermiquement isolante d'un four de cristallisation selon un procédé de solidification dirigée, ledit matériau ayant un coefficient de variation de volume à la solidification connu et différent de 0, ledit procédé comprenant les étapes suivantes :

- détection de la position de l'interface vapeur-liquide (3) du bain de matériau fondu au temps (t),
- déduction de la position de l'interface liquide-solide (4) au temps (t) par l'intermédiaire du calcul de la variation de la position de l'interface liquide-solide entre l'instant (t) et un instant initial, en multipliant la variation de la position de l'interface vapeur-liquide entre l'instant (t) et l'instant initial par le coefficient $\rho_{liq} / (\rho_{liq} + \rho_{sol})$, où $\rho_{liq}$ et $\rho_{sol}$ représentent respectivement la masse volumique du matériau liquide et la masse volumique du matériau solide ;
le procédé étant **caractérisé en ce que** l'étape de détection de la position de l'interface vapeur-liquide (3) comprend les étapes suivantes :
- envoi d'une onde ultrasonore sur l'interface vapeur-liquide (3) selon un angle aigu par rapport à la normale à l'interface vapeur-liquide,
- détection de l'onde ultrasonore réfléchie par l'interface vapeur-liquide (3),
l'envoi et la détection de l'onde ultrasonore se faisant à l'aide du dispositif de contrôle selon l'une quelconque des revendications 1 à 7.

**9.** Procédé de contrôle selon la revendication 8, comprenant en outre, après l'étape de détection de la position de l'interface vapeur-liquide (3), les étapes suivantes :

- détection de la position z de l'interface vapeur-liquide (3) du bain de matériau fondu au temps (t+a), a étant le laps de temps séparant la détection au temps (t) et la détection au temps (t+a) ;
- détermination de la vitesse de l'interface vapeur-liquide (3) selon la formule suivante :

$$V_{vapeur-liquide} = \frac{z(t+a) - z(t)}{a}$$

**10.** Procédé de contrôle selon la revendication 8, comprenant en outre, après l'étape de détection de la position de l'interface vapeur-liquide (3), les étapes suivantes :

- détection de la position z de l'interface vapeur-liquide du bain de matériau fondu au temps (t+a), a étant le laps de temps séparant la détection au temps (t) et la détection au temps (t+a) ;
- déduction de la position z' de l'interface liquide-solide (4) au temps (t+a) par l'intermédiaire du calcul de la variation de la position de l'interface liquide-solide entre l'instant (t+a) et l'instant (t), en multipliant la variation de la position de l'interface vapeur-liquide entre l'instant (t+a) et l'instant (t) par le coefficient $\rho_{liq} / (\rho_{liq} + \rho_{sol})$, où $\rho_{liq}$ et $\rho_{sol}$ représentent respectivement la masse volumique du matériau liquide et la masse volumique du matériau solide ;
- détermination de la vitesse de l'interface liquide-solide selon la formule suivante :

$$V_{liquide-solide} = \frac{z'(t+a) - z'(t)}{a}$$

**Patentansprüche**

1. Vorrichtung zur Überwachung des Fortschritts der Kristallisierung eines Schmelzebades, die in einer thermisch isolierenden Umhüllung eines Kristallisierungsofens gemäß einem Prozess einer gerichteten Erstarrung durchgeführt wird, aufweisend eine Ultraschallquelle (5) und einen Ultraschalldetektor (6), **dadurch gekennzeichnet, dass**:

   die Ultraschallquelle (5) n Einheit(en) aufweist, wobei n eine ganze Zahl größer oder gleich 1 ist, wobei jede Einheit der Quelle einen Transducer (7) aufweist, der geeignet ist, eine Ultraschallwelle auszusenden, und der mit einem Wellenleiter (8) verbunden ist, welcher geeignet ist, die Ultraschallwelle, die von dem Transducer erzeugt wird, zur Dampf-Flüssigkeit-Grenzfläche (3) des Schmelzebades zu lenken;
   der Ultraschalldetektor (6) mindestens 2n Einheiten aufweist, wobei jede Einheit des Detektors einen Wellenleiter (10) aufweist, der mit einem Transducer (9) verbunden ist, welcher geeignet ist, eine Ultraschallquelle zu erfassen, wobei der Wellenleiter (10) geeignet ist, eine Ultraschallwelle zu dem Transducer zu leiten;
   und **dadurch gekennzeichnet, dass** die n Einheiten der Quelle und die mindestens 2n Einheiten des Detektors oberhalb der Dampf-Flüssigkeit-Grenzfläche (3) des Schmelzebades in verschiedenen Positionen angeordnet sind, derart, dass die durch einen Transducer der Quelle erzeugte Ultraschallwelle auf die Dampf-Flüssigkeit-Grenzfläche in einem spitzen Winkel bezüglich der Normalen auf die Grenzfläche auftrifft und diese Ultraschallwelle, die durch die Dampf-Flüssigkeit-Grenzfläche in dem gleichen spitzen Winkel reflektiert wird, durch einen Transducer des Detektors erfasst wird,
   die Transducer der Quelle und des Detektors sich auf der Außenseite der Umhüllung befinden und die Wellenleiter der Quelle und des Detektors die Wand der Umhüllung durchqueren,
   und die Wellenleiter eine Ultraschall-Eintrittsfläche, eine Ultraschall-Austrittsfläche und eine diese beiden Flächen verbindende Seitenfläche aufweisen, wobei die Flächen zwischen den Eintrittsflächen und den Austrittsflächen der Wellenleiter, welche zum Inneren der Umhüllung weisen, von einer porösen Schicht (11) überzogen sind, die eine Impedanzanpassung zwischen den Wellenleitern und der Atmosphäre der Umhüllung erlaubt, wobei die poröse Schicht eine Dichte von weniger als 1000 kg/m$^3$ hat.

2. Vorrichtung zur Überwachung nach Anspruch 1, wobei die poröse Schicht ein Aerogel aus kristallinem Siliziumdioxid oder expandierter Graphitschaum ist.

3. Vorrichtung zur Überwachung nach Anspruch 1, wobei die poröse Schicht eine Dichte von weniger als 500 kg/m$^3$ hat.

4. Vorrichtung zur Überwachung nach Anspruch 1, wobei die Wellenleiter der Quelle und des Detektors aus kristallinem Siliziumdioxid oder kristallinem Aluminiumdioxid bestehen.

5. Vorrichtung zur Überwachung nach Anspruch 1, wobei die Wellenleiter des Detektors gemäß einer Matrix (i x j) angeordnet sind, mit i Reihen und j Spalten, wobei i und j ganze Zahlen größer oder gleich 1 sind, und i x j ≥ 2.

6. Vorrichtung zur Überwachung nach Anspruch 1, wobei der spitze Winkel zwischen 40° und 70°, und vorzugsweise zwischen 50° und 60° beträgt.

7. Vorrichtung zur Überwachung nach Anspruch 1, wobei die Transducer der Quelle und des Detektors Transducer vom piezoelektrischen oder magnetostriktiven Typ sind.

8. Verfahren zur Überwachung des Fortschritts der Kristallisierung eines Schmelzebades, die in einer thermisch isolierenden Umhüllung eines Kristallisierungsofens gemäß einem Prozess einer gerichteten Erstarrung durchgeführt wird, wobei das Schmelzematerial einen bekannten Erstarrungsvolumenänderungskoeffizienten hat, der von 0 verschieden ist, wobei der Prozess die folgenden Schritte umfasst:

   Erfassen der Position der Dampf-Flüssigkeit-Grenzfläche (3) des Schmelzebades zum Zeitpunkt (t),
   Herleiten der Position der Flüssigkeit-Feststoff-Grenzfläche (4) zum Zeitpunkt (t) mittels Berechnung der Änderung der Position der Flüssigkeit-Feststoff-Grenzfläche zwischen dem Zeitpunkt (t) und einem Anfangszeitpunkt, durch Multiplizieren der Änderung der Position der Dampf-Flüssigkeit-Grenzfläche zwischen dem Zeitpunkt (t) und dem Anfangszeitpunkt mit dem Koeffizienten $\rho_{liq}/(\rho_{liq} + \rho_{sol})$, wobei $\rho_{liq}$ und $\rho_{sol}$ die Dichte des flüssigen Materials bzw. die Dichte des festen Materials repräsentieren;
   und der Prozess **dadurch gekennzeichnet ist, dass** der Schritt zur Erfassung der Position der Dampf-Flüssigkeit-Grenzfläche (3) die folgenden Schritte umfasst:

Aussenden einer Ultraschallwelle auf die Dampf-Flüssigkeit-Grenzfläche (3) in einem spitzen Winkel zur Normalen auf die Dampf-Flüssigkeit-Grenzfläche,
Erfassen der durch die Dampf-Flüssigkeit-Grenzfläche (3) reflektierten Ultraschallwelle,
wobei das Aussenden und das Erfassen der Ultraschallwelle mittels einer Vorrichtung zur Überwachung nach einem der Ansprüche 1 bis 7 erfolgt.

9. Verfahren zur Überwachung nach Anspruch 8, das weiter, nach dem Schritt zur Erfassung der Position der Dampf-Flüssigkeit-Grenzfläche (3), die folgenden Schritte umfasst:

Erfassen der Position z der Dampf-Flüssigkeit-Grenzfläche (3) des Schmelzebades zum Zeitpunkt (t+a), wobei a die Zeitspanne ist, welche die Erfassung zum Zeitpunkt (t) und die Erfassung zum Zeitpunkt (t+a) trennt;
Bestimmen der Geschwindigkeit der Dampf-Flüssigkeit-Grenzfläche (3) gemäß der folgenden Formel:

$$V_{\text{Dampf-Flüssigkeit}} = \frac{z(t+a) - z(t)}{a}$$

10. Verfahren zur Überwachung nach Anspruch 8, das weiter, nach dem Schritt zur Erfassung der Position der Dampf-Flüssigkeit-Grenzfläche (3), die folgenden Schritte umfasst:

Erfassen der Position z der Dampf-Flüssigkeit-Grenzfläche des Schmelzebades zum Zeitpunkt (t+a), wobei a die Zeitspanne ist, welche die Erfassung zum Zeitpunkt (t) und die Erfassung zum Zeitpunkt (t+a) trennt;
Herleiten der Position z' der Flüssigkeit-Feststoff-Grenzfläche (4) zum Zeitpunkt (t+a) mittels Berechnung der Änderung der Position der Flüssigkeit-Feststoff-Grenzfläche zwischen dem Zeitpunkt (t+a) und dem Zeitpunkt (t), durch Multiplizieren der Änderung der Position der Dampf-Flüssigkeit-Grenzfläche zwischen dem Zeitpunkt (t+a) und dem Zeitpunkt (t) mit dem Koeffizienten $\rho_{\text{liq}}/(\rho_{\text{liq}} + \rho_{\text{sol}})$, wobei $\rho_{\text{liq}}$ und $\rho_{\text{sol}}$ die Dichte des flüssigen Materials bzw. die Dichte des festen Materials repräsentieren;
Bestimmen der Geschwindigkeit der Flüssigkeit-Feststoff-Grenzfläche gemäß der folgenden Formel:

$$V_{\text{Flüssigkeit-Feststoff}} = \frac{z'(t+a) - z'(t)}{a}$$

**Claims**

1. Device for monitoring the state of progress of crystallisation of a bath containing molten material made in a thermally insulating chamber in a crystallisation furnace using a controlled solidification method, including an ultrasound source (5) and an ultrasound detector (6), **characterised in that**:

- the ultrasound source (5) comprises n assembly(ies) where n is an integer number greater than or equal to 1, each source assembly comprising a transducer (7) capable of emitting an ultrasound wave, connected to a wave guide (8) capable of guiding the ultrasound wave produced by said transducer, to the vapour-liquid interface (3) of the liquid bath;
- the ultrasound detector (6) comprises at least 2n assemblies, each detector assembly comprising a wave guide (10) connected to a transducer (9) capable of detecting an ultrasound wave, said wave guide (10) being capable of guiding an ultrasound wave to said transducer;
and **characterised in that** the n source assemblies and the at least 2n detector assemblies are placed above the vapour-liquid interface (3) of the liquid bath at distinct positions such that the ultrasound wave produced by a source transducer is incident on the vapour-liquid interface at an acute angle from the normal to said interface, and that this ultrasound wave reflected by the vapour-liquid interface at this same acute angle is detected by a transducer of the detector,
the source and detector transducers are located outside the chamber and the source and detector wave guides pass through the wall of said chamber,
and the wave guides comprise an ultrasound wave input face, an ultrasound wave output face and a lateral surface connecting these two faces, the faces among the input faces and output faces of the wave guides that point towards the inside of the chamber being covered by a porous layer (11) that can create impedance matching between the wave guides and the atmosphere of the chamber, said porous layer having a density of less than 1000 kg/m$^3$.

2. Monitoring device according to claim 1, wherein the porous layer is a crystalline silica aerogel or an expanded graphite foam.

3. Monitoring device according to claim 1, wherein the density of the porous layer is less than 500 kg/m$^3$.

4. Monitoring device according to claim 1, wherein the source and detector wave guides are made of crystalline silica or crystalline alumina.

5. Monitoring device according to claim 1, wherein the detector wave guides are arranged in a matrix (ixj) with i rows and j columns, where i and j are integer numbers greater than or equal to 1 and $i \times j \geq 2$.

6. Monitoring device according to claim 1, wherein the acute angle is between 40° and 70°, and preferably between 50° and 60°.

7. Monitoring device according to claim 1, wherein the source and detector transducers are piezoelectrical or magnetostrictive type transducers.

8. Method for monitoring the state of progress of crystallisation of a bath containing a molten material made in a thermally insulating chamber of a crystallisation furnace according to a controlled solidification process, said material having a known coefficient of volume variation at solidification that is not equal to 0, said method including the following steps:

   - detection of the position of the vapour-liquid interface (3) in the bath of molten material at time (t),
   - deduction of the position of the liquid-solid interface (4) at time (t) by calculating the variation of the position of the liquid-solid interface between time (t) and an initial time, by multiplying the variation of the position of the vapour-liquid interface between time (t) and the initial time by the coefficient $\rho_{liq}/(\rho_{liq} + \rho_{sol})$, where $\rho_{liq}$ and $\rho_{sol}$ represent the density of the liquid material and the density of the solid material respectively;
   the method being **characterised in that** the step to detect the position of the vapour-liquid interface (3) includes the following steps:
   - send an ultrasound wave onto the vapour-liquid interface (3) at an acute angle from the normal to the vapour-liquid interface;
   - detection of an ultrasound wave reflected by the vapour-liquid interface (3),
   the ultrasound wave being transmitted and detected using the monitoring device according to any one of claims 1 to 7.

9. Monitoring method according to claim 8, further comprising the following steps after the step to detect the position of the vapour-liquid interface (3):

   - detect the position z of the vapour-liquid interface of the bath containing molten material at time (t+a), where a is the time lag separating detection at time (t) and detection at time (t+a);
   - determine the velocity of the vapour-liquid interface (3) using the following formula:

$$V_{\text{vapour-liquid}} = \frac{z(t + a) - z(t)}{a}$$

10. Monitoring method according to claim 8, further comprising the following steps after the step to detect the position of the vapour-liquid interface (3):

   - detect the position z of the vapour-liquid interface of the molten material bath at time (t+a), where a is the time lag between detection at time (t) and detection at time (t+a);

- deduce the position z' of the liquid-solid interface (4) at time (t+a) by calculating the variation of the position of the liquid-solid interface between time (t+a) and time (t), by multiplying the variation of the position of the vapour-liquid interface between time (t+a) and time (t) by the coefficient $\rho_{liq}/(\rho_{liq} + \rho_{sol})$, where $\rho_{liq}$ and $\rho_{sol}$ respectively represent the density of the liquid material and the density of the solid material

- determine the velocity of the liquid-solid interface using the following formula:

$$V_{\text{liquid-solid}} = \frac{z'(t+a) - z'(t)}{a}$$

# FIGURE

## RÉFÉRENCES CITÉES DANS LA DESCRIPTION

**Littérature non-brevet citée dans la description**

- **C. SALVI ; J.P. GARANDET.** A novel resistance technique in the field of directional solidification. *Review of Scientific Instruments,* 2001, vol. 72, 255-262
- **P. DOLD ; M. HEIDLER ; A. DREVERMANN ; G. ZINIMERMANN.** In situ observation of growth interfaces by ultrasound. *Journal of Crystal Growth,* 2003, vol. 256, 352-360
- **T. GUDRA ; Z. KOJRO ; M . SCHMACHTL ; C. LIER ; M. SCHUBERT ; W. GRILL.** Scanning acoustic air microscope. *Ultrasonics,* 1996, vol. 34, 711-719